Europäisches Patentamt

(19) European Patent Office

Office européen des brevets

(11) Publication number: **0 363 547 B1**

(12) **EUROPEAN PATENT SPECIFICATION**

(45) Date of publication of patent specification: **29.12.93**   (51) Int. Cl.⁵: **H01L  21/306**, H01L 21/00, G03F 7/004

(21) Application number: **88810613.5**

(22) Date of filing: **12.09.88**

(54) Method for etching mirror facets of III-V semiconductor structures.

(43) Date of publication of application:
**18.04.90 Bulletin  90/16**

(45) Publication of the grant of the patent:
**29.12.93 Bulletin  93/52**

(84) Designated Contracting States:
**DE FR GB IT**

(56) References cited:
**WO-A-80/00639**
**DE-A- 1 622 333**

**APPLIED PHYSICS LETTERS, vol. 50, no. 23, 8th June 1987, pages 1640-1641, New York, US ; P. THIHANYI et al. : "High-power AlGaAs/GaAs single quantum well lasers with chemically assisted ion beam etched mirrors"**

**JOURNAL OF VACUUM SCIENTIFIC TECHNOLOGY, vol. B3, no. 1, January/February 1985, pages 402-405, US ; K. ASAKAWA et al. : "GaAs and A1GaAs anisotropic fine pattern etching using a new reactive ion beam etching system"**

(73) Proprietor: **International Business Machines Corporation**
**Old Orchard Road**
**Armonk, N.Y. 10504(US)**

(72) Inventor: **Buchmann, Peter, Dr.**
**Unterrenggstrasse 36**
**CH-8135 Langnau am Albis(CH)**
Inventor: **Dietrich, Hans-Peter**
**Eggstrasse 9**
**CH-8134 Adliswil(CH)**
Inventor: **Vettiger, Peter**
**Langmoosstrasse 33**
**CH-8135 Langnau am Albis(CH)**

(74) Representative: **Barth, Carl Otto et al**
**IBM Corporation**
**Zurich Intellectual Property Dept.**
**Säumerstrasse 4**
**CH-8803 Rüschlikon (CH)**

IBM TECHNICAL DISCLOSURE BULLETIN, vol. 24, no. 6, November 1981, pages 3037-3038, New York, US ; J.S. LOGAN : "Structure for Reduction of E-Beam charging on Multilevel Metal Structures"

JOURNAL OF THE ELECTROCHEMICAL SOCIETY, vol. 133, no. 8, August 1986, pages 1755-1756, Manchester, NH, US ; M. KAKUCHI et al. : "Electrically Conducting Two-Layer Resist System Using Amorphous Carbon Films"

## Description

Technical Field

The invention concerns a method for etching mirror facets of III-V semiconductor structures such as laser diodes or waveguides applying an ion beam etching process in which a multi-layer mask is used for the definition of the mirror facets. The invention also concerns a multi-layer mask structure for use in ion beam etching systems. The methods are particularly suited for full-wafer processing techniques that permit the fabrication of the laser structures and the associated electronic and electro-optical devices on the same chip.

Background of the Invention

Semiconductor diode lasers have found applications in a wide variety of information handling systems because of their compact size and because their technology is compatible with that of the associated electronic circuitry.

More recently, there is a strong trend to increase the scale of integration of opto-electronic integrated circuits (OEIC). This requires the replacement of at least one cleaved mirror facet of the diode laser by an etched mirror. III-V compounds are of special interest. If good quality etched mirrors can be produced, this not only permits the integration of monitor photodiodes and electronic circuits but also allows to perform processes like mirror coating and testing on the wafer level. This with the benefit of reduced handling, increased yield and decreased fabrication and testing costs.

In addition to these improvements in integration and fabrication, etched mirrors make it possible to realize very short cavity lasers, groove-coupled cavity lasers, beam deflectors and surface emitters. Also, new types of laser and waveguide structures with curved and angled mirror facets, which are of interest in integrated optic circuits, can be fabricated using etching processes.

A key technical problem in the fabrication of integrated lasers is to achieve high quality mirrors having vertical smooth facets with low surface roughness (in the order of ten's of nm), that are not deteriorated by particle deposition or surface damage. Good mirrors being a prerequisite for high beam quality, low threshold current density lasers, a relatively simple and reproducible etching method for their fabrication is in demand.

The aim is, to develop methods for forming laser mirrors having a quality at least similar to that of cleaved lasers thus not seriously compromising laser performance. In order to obtain such smooth mirror facets in an etch process that results in a groove with vertical walls, which then form the mirror facets, the use of low edge roughness etch masks is mandatory. These masks also need to be highly etch resistant in order not to become severely deteriorated during the etch process and not to cause formation of particles that could become redeposited on the etched mirror facets. Single- and multiple-layer masks have been designed to meet these requirements to the extent possible.

A number of processes, such as chemical etching, plasma etching and ion etching have been proposed for mirror etching. An advanced process that has been suggested, is the so-called reactive ion beam etch (RIBE) process where a reactive ion beam is used to anisotropically etch the groove into the laser diode structure formed in a stack of AlGaAs layers of varying Al content deposited on a semiconductor substrate.

Such RIBE processes and the obtained laser diode structures have been described in a number of publications for which the following are representative :

-   Article by K.Asakawa et al : "GaAs and AlGaAs Anisotropic Fine Pattern Etching using a new Reactive Ion Beam Etching System" (J.Vac.Sci.Technol. B 3, Jan/Feb 1985, pp 402-405).

The authors have achieved high-aspect ratio GaAs deep anisotropic fine pattern etching by using a $Cl_2$ RIBE system. In an ultra-high vacuum chamber, deep anisotropic etching and equirate etching of GaAs and AlGaAs has been obtained by using a high-temperature (250°C) baked photoresist mask with a sharp cut profile rather than a conventional soft-baked mask baked at low temperature. The described mask is a multi-layer structure with top and bottom photoresist (PR) layers, baked at 90 and 250°C, respectively, and with an intermediate layer of titanium (Ti) sandwiched inbetween.

-   Article by M.Mannok et al : "Low-Threshold MBE GaAs/AlGaAs Quantum Well Lasers with dry-etched Mirrors" (Electronic Letters, August 1985, Vol.21, No.17, pp 769 - 770).

Described is a process for the fabrication of GaAs/AlGaAs quantum well (QW) lasers with etched mirrors. A RIBE process, employing the PR - titanium - PR multi-layer mask disclosed in the above Asakawa paper, is used to fabricate GaAs/AlGaAs lasers. Threshold currents of 30 mA and an external quantum well efficiency of 41 % have been achieved.

3

- Article by T.Yuasa et al : "Short Cavity GaAs/AlGaAs Multiquantum Well (MQW) Lasers by dry-etching" (Appl. Phys. Lett. 49 (16), Oct. 1986, pp 1007 - 1009).

The authors describe a RIBE process, using $Cl_2$, applied to fabricate etched mirror facets of GaAs/AlGaAs lasers. The multi-layer mask used consists of a top 80° C-baked photoresist, a Ti intermediate layer, and a bottom high-temperature baked photoresist layer. The laser structure fabricated is reported to operate at threshold currents as low as about 38 mA for 20 $\mu$m-long cavity structures.

More recently, another technique has been employed in fabricating laser structures with etched mirror facets : Chemically Assisted Ion Beam Etching (CAIBE). Here, an ion beam, for instance of Ar + ions, is directed at the surface of the structure to be etched. The etch rate is substantially increased, by a factor of 100 to 200, by applying a stream of reactive gas, e.g., $Cl_2$, to the surface. In comparison to the RIBE process, the same etch rates are obtained with a largely reduced ion current density. This results in reduced damages and therefore smoother facet surfaces. As of today, the CAIBE technique is considered the best known for the fabrication of vertical etched mirror facets in GaAs/AlGaAs laser structures with arbitrary Al-concentrations. At very low water pressure in the process chamber, non-selective etching of AlGaAs with an Al concentration of up to 65 % is possible.

A general and more detailed description of the CAIBE process can be found in a paper "Ion Beam Etching with Reactive Gases" by L.D. Bollinger (Solid State Technology Jan. 1983).

One such process and its application in producing etched laser structures has been disclosed in an article by P.Tihanyi et al : "High-Power AlGaAs/GaAs Single Quantum Well Lasers with Chemically Assisted Ion Beam Etched Mirrors" (Appl.Phys.Lett 50 (23), June 1987, pp 1640-1641).

This is a report on the use of a CAIBE process to form laser mirrors in graded-index separated-confinement heterostructure (GRINSCH) lasers. In the process, a single, patterned chromium (Cr) layer serves as mask for the etch of the mirror groove. As stated in the article, the obtained lasers, with one mirror etched, the other cleaved, have threshold currents about 30 % higher than corresponding lasers with both mirrors cleaved. The external quantum efficiency also does not quite reach that of a cleaved device, 27 % were achieved vs 40 %.

Although substantial advancements have been made towards obtaining the same overall mirror quality and laser device performance as with the best known cleaving techniques, the hitherto proposed mirror etching techniques such as those disclosed in the above cited references have not quite reached this goal yet. Depending on the process used, good values have been achieved for one or more of the essential laser parameters, such as threshold current density, external quantum efficiency, far field beam quality and mirror reflectivity, but there is still no mirror etch process known that satisfies all requirements to a sufficient degree.

Some of the problems and drawbacks encountered with the known processes can be summarized as follows :

- Use of a multi-layer mask structure having a metallic (Ti) intermediate layer, leads to a certain roughness of the mask edge pattern because of the micro-crystallinity of the metal; consequently, the resulting mirror facets are not as smooth as desired.
- In practice, the complete removal of such metallic intermediate layers prior to the mirror etch step and without damaging the adjacent mask and laser layers is very difficult to accomplish. However, if the metal layer, or parts of it, is not removed, the metal is eroded during etching and metal particles, redeposited at the facet surfaces, add to the surface roughness. This is particularly critical since the intermediate layer has a small overhang, i.e., it is some nm wider than the resist stencil, and is thus very exposed to erosion during the facet etch process. In other words, the actual masking edge recedes during the process, resulting in increased facet roughness.
- Use of a patterned metallic (Cr, Ni) film as a single-layer mask also leads to surface roughness because of the micro-crystallinity of the mask metal, and because of particle redeposition at the facets. Furthermore, under the given process conditions, the formation of a Cr or Ni mask pattern is difficult and may itself add to the facet roughness.

It is a main object of the present invention to provide a method for etching semiconductor diode laser mirrors of same or at least similar quality than that of mirrors obtained by using a conventional high-quality cleaving technique.

Another main object is to provide a multi-layer etching mask for use in ion beam etch processes of such precision and quality that it can be used to produce extremely low roughness facets.

A further object is to provide a multi-layer etching mask having very smooth pattern edges and being highly resistant to the reactive gas or plasma used in the etching process, and that is easy to remove under fabrication process conditions.

4

## Summary of the Invention

The invention as defined in the claims is intended to meet these objectives and to remedy the drawbacks and deficiencies of known laser mirror etch techniques. The inventive method solves the problems hitherto encountered by using, in an ion beam etch process, a multi-layer etch mask structure with an intermediate layer of amorphous di-electric material sandwiched between two PR layers, and by removing that intermediate layer prior to the etch process whereby the precise and highly etch-resistant, hard-baked bottom PR layer becomes the only mask layer for the etch process.

The advantages offered by the invention are mainly that the used mask has an almost vertical and very smooth edge profile, that the mask is resistant to the reactant gas used in the etch process thereby avoiding mask erosion and maintaining the smooth profile throughout the etch process, and that mask formation is compatible with the laser fabrication process. The inventive mirror etching method, using the multi-layer mask, offers a simple, reproducible fabrication process for very low roughness mirror facets in III-V compound devices, particularly AlGaAs structures with arbitrary Al concentration.

## Description of the Drawings

The invention is described in detail below with reference to drawings which illustrate a specific embodiment of the invention, and in which

Fig. 1A - 1C      are schematic representations of a ridge SQW laser diode showing
        (A) the completed ridge structure prior to mirror groove etching;
        (B) the ridge structure after removal of part of the insulation layer; and
        (C) the ridge structure with the mirror groove etched.
Fig. 2A - 2G      are illustrations of the steps of the inventive mirror etching method.
Fig. 3A - 3B      are diagrams comparing device parameters of lasers having etched and cleaved mirrors, respectively.

## Detailed Description

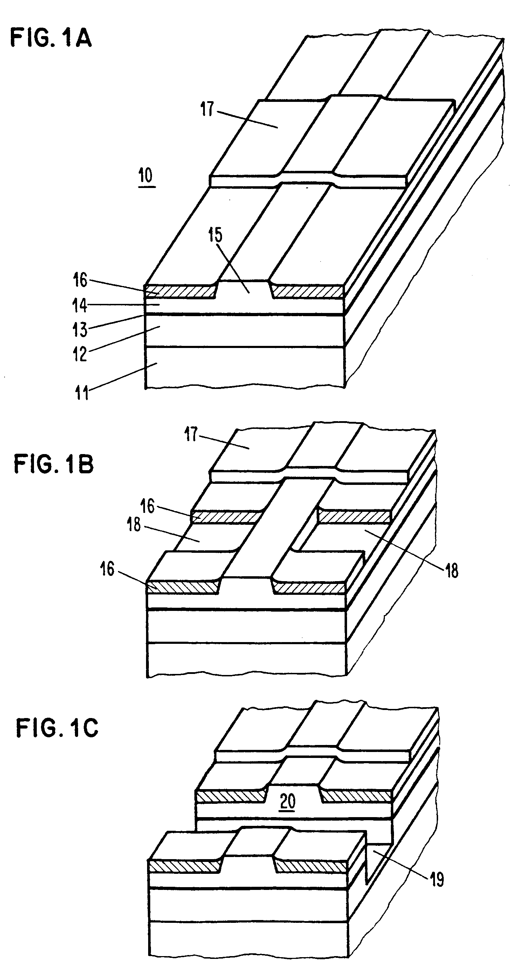

Before describing the invention in greater detail, a possible application of the inventive method will be outlined with the aid of Fig.1A to 1C. In the example chosen, the laser device is a ridged single quantum well (SQW) structure deposited on a semiconductor substrate.

Fig.1A schematically illustrates the main elements of the laser structure 10. The drawing shows the laser structure essentially completed but prior to mirror facet etching. Successively deposited on a GaAs substrate 11 are: the lower AlGaAs cladding layer 12, the active GaAs layer 13 forming the quantum well, and the upper AlGaAs cladding layer 14. The latter has been etched to form a ridge 15. The etched regions adjacent the active ridge structure are covered with an insulation layer 16 which may consist of silicon nitride ($Si_3N_4$). It is resistant to the etchant used in the mirror facet etch process. A metallization layer 17, deposited on top of the layered laser structure, is schematically indicated.

Fig.1B illustrates how a window, etched into the insulation layer 16, exposes the region 18 where the groove, providing the mirror facets, is to extend laterally beyond the ridge region (the latter not being covered by insulation 16).

Finally, Fig.1C shows the laser structure after completion of the groove etching process. The vertical wall of etched groove 19 provides the mirror facet 20. The width of the groove can be adapted to the needs, typically it may be in the order of 6 to 8 $\mu$m; its depth, for the type of laser illustrated, about 3 to 4 $\mu$m.

Prerequisits for an etch method that is applied to form grooves in a semiconductor structure, the walls of the grooves, in turn, providing for the required high quality mirror facets, are :
- a precise mask that maintains its pattern during the groove etch process, and
- an etch process that results in vertical, low roughness grooved edges.

In the inventive process, a 3-layer mask structure is used comprising a bottom layer of hard-baked photoresist, an amorphous dielectric intermediate layer (e.g. of SiO), and a top soft-baked photoresist layer.

The two upper layers serve to precisely pattern the bottom layer : the lithographically obtained pattern of the top PR layer is first transferred into the intermediate layer (using, e.g., a $CF_4$ reactive ion etch (RIE) step), and then into the bottom PR layer (using, e.g., $O_2$-RIE); with this last step, the patterned top PR layer is simultaneously removed.

Since the accurateness of the pattern in the hard-baked PR layer is determined by the accuracy and smoothness of the pattern of the intermediate layer, an amorphous dielectric material such as SiO is used rather than a metal (like Ti) that is micro-crystalline and thus exhibits some edge roughness.

Then, still prior to groove etching, the patterned intermediate layer is removed. A $CF_4$-RIE process can again be used. This avoids the erosion during the subsequent groove etch process which would otherwise lead to particle formation and their redeposition at the walls of the groove. This removal also avoids the problem of a receding actual masking edge during the etching process. Since the intermediate layer consists of a dielectric such as SiO, complete removal can be achieved in a simple process step - in contrast to problems one would encounter when using a metallic intermediate layer.

At this stage, only the patterned bottom PR layer is left to serve as a mask for the groove etch. The hard-baked PR is highly etch resistant to the etchant used ($Cl_2$), i.e., the etch rate ratio AlGaAs : mask PR is high. Consequently, mask degradation during the deep etch process does not become critical.

For the subsequent groove etch, a CAIBE process, using $Cl_2$, is applied. This directional etch process provides for vertical groove walls. Since the etch rate for AlGaAs is, in this process, virtually independent of the Al-content (up to 65 %), the etched walls show very low roughness.

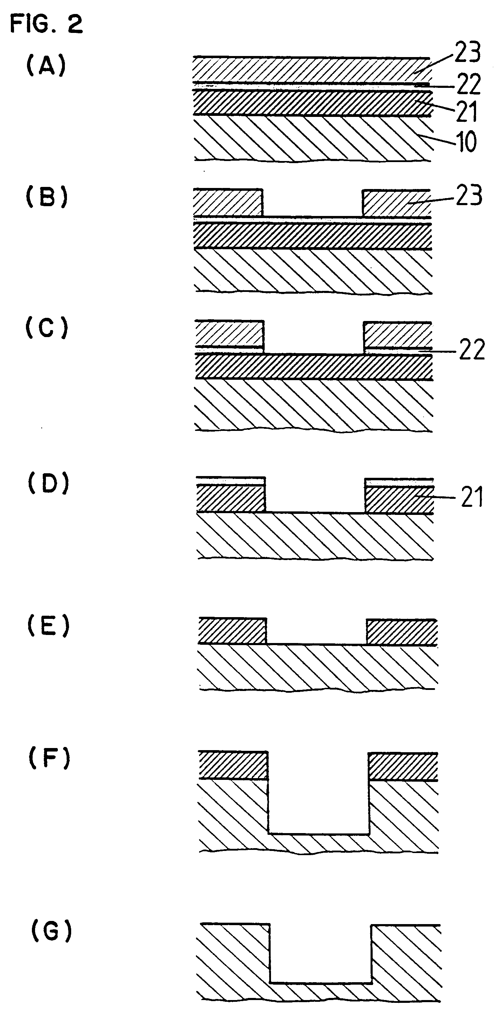

In Fig.2A to 2G, the subsequent steps of the inventive process applied to produce the etched mirror facets, are illustrated in detail. The successive steps are listed in table I which shows the correspondence between the steps and the drawings.


## TABLE I


| Step No. | Description of Process Step | Figure |
|---|---|---|
| Starting Point | A layered GaAs/AlGaAs laser structure (mirror facets not yet etched) covered with a 3-layer mask comprising (1) a hard-baked bottom | 2A |

6

photoresist layer 21,

(2) an intermediate dielectric layer 22 (SiO), and

(3) a top imaging layer of soft-baked photoresist 23

| | | |
|---|---|---|
| 1 | Patterning the imaging resist layer 23 | 2B |
| 2 | Pattern transfer from imaging resist into intermediate layer by $CF_4$-RIE | 2C |
| 3 | Pattern transfer from inter-mediate layer into bottom hard-baked resist by $O_2$-RIE with simultaneous removal of top resist layer 23 | 2D |
| 4 | Removal of intermediate SiO layer by $CF_4$-RIE with simul-taneous patterning of the insu-lation covering the laser struc-ture adjacent the ridges (Fig.1B) | 2E |
| 5 | Mirror facet etching by CAIBE | 2F |
| 6 | Mask (lower resist layer 21) removal by ashing in oxygen plasma | 2G |

As illustrated in Fig.2A, the process is initiated starting from a layered GaAs/AlGaAs laser structure (10 in Fig.1A) ready for mirror facet etching. The structure is covered with a 3-layer mask comprising :

(1) a bottom layer 21 of an AZ-type photoresist (AZ 4110 chosen in the example) of 1.2 $\mu$m thickness, obtained by spinning at 3000 rpm for 30 s and subsequent hard-baking at 200 °C for 30 minutes in air;

(2) an amorphous dielectric layer 22 of SiO with a thickness of 100 nm, evaporated at a rate of 1 nm/s with indirect beam heating;

(3) a top imaging AZ-type photoresist layer 23 (AZ 4110) of 0.9 $\mu$m thickness, obtained by spinning at 6000 rpm for 30 s and subsequent pre-baking at 90 °C for 20 minutes in air.

In the first step of the process, the top imaging resist layer 23 is patterned to define the mirror groove that is to be etched. The required precise pattern is obtained using conventional lithography involving

7

exposing, developing, rinsing, drying, post-baking. These processes lead to the structure illustrated in Fig.2B.

Subsequently, the structure is loaded into a RIE system where the next three steps are performed in situ :

In step 3, illustrated in Fig.2C, the exposed portion of the intermediate SiO layer 22 is reactive ion etched (RIE) in a $CF_4$ plasma, at 10 $\mu$bar (= 1 Pa), 0.15 W/cm$^2$ for EPD + 2 min, at an etch rate of about 20 nm/min.

After changing the plasma in the RIE system from $CF_4$ to $O_2$, the exposed portion of the hard-baked bottom resist 21 is etched in step 3 (Fig.2D). At 1 Pa (= 10 $\mu$bar), 0.15 W/cm$^2$, for EPD + 10 min, the layer is etched at a rate of about 70 nm/min. The patterned top resist layer 23 is removed at the same time.

Next, the RIE system is again switched to $CF_4$. In the following process step 4, the remainder of the patterned intermediate SiO layer is removed at an etch rate of about 25 nm/min (at 1 Pa (= 10 $\mu$bar), 0.15 W/cm$^2$, EPD + 5 min). The resulting mask structure is shown in Fig.2E. With the same process, the exposed underlying insulation covering the laser structure adjacent the ridge, is removed opening a window that defines the extension of the mirror groove beyond the laser ridge. This step is also illustrated in Fig.1B where the insulation layer carries the reference number 16.

Now the laser structure is loaded into a high-vacuum CAIBE system where the actual etching of the mirror groove is to take place (step 5). After establishing the vacuum (total pressure : below $1,3 \times 10^{-5}$ Pa (= $10^{-7}$ Torr); $H_2O$ : below $1,3 \times 10^{-6}$ Pa (= $10^{-8}$ Torr)), the Argon (Ar +) flow (2 sccm), the ion source (increasing from 100 eV, 25 $\mu$A/cm2, to 500 eV, 150 $\mu$A/cm2), and the $Cl_2$ flow (10 sccm) are switched on. With an etch rate of 0.3 $\mu$m/min and an etching time of about 15 min, the etched groove reaches the desired depth of about 4 to 5 $\mu$m; it penetrates through the upper cladding layer, the active layer, and far into or through the lower cladding layer of the laser structure (Fig.2F).

Finally, in step 6, the substrate is loaded into an asher where the remainder of the hard-baked mask is removed in an oxygen plasma (at 65 Pa (= 0,5 Torr), 550 W). This is followed by rinsing in Acetone and Isopropanol. The completed mirror groove is shown in Fig.2G. It is also illustrated in Fig.1C.

The invention has been described in detail as applied to the fabrication of a specific diode laser, i.e., an AlGaAs/GaAs ridge structure. It should however be understood that the invention is also applicable to other opto-electronic structures and techniques. Another example being a GRINSCH structure. Semiconductor materials other than AlGaAs may be used and various other modifications made. For example, optical reduction printing or electron beam direct writing may be employed instead of contact printing to further improve the mask and thus the mirror facet quality. Also, the material for the intermediate layer, in the example SiO, may be replaced by another amorphous dielectric, and, in general, the process parameters, etchants or plasma used, the indicated thicknesses and other device characteristics chosen for the description of the embodiment, may be changed.

GaAs/AlGaAs SQW GRINSCH lasers with etched mirrors fabricated using the mask and process described herein show characteristics and performance very close to that of corresponding lasers with cleaved mirrors produced on the same wafer.

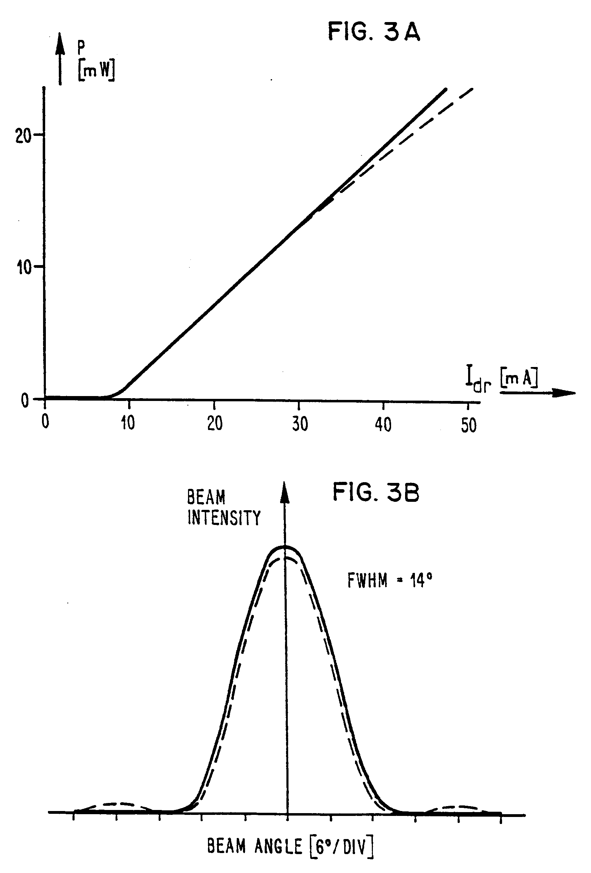

For two of the most important laser characteristics this is illustrated in Fig.3A and 3B showing diagrams in which the solid curves represent the cleaved lasers whereas the dotted curves represent the behavior of lasers having etched mirrors at both ends of the resonant cavity.

In the diagram of Fig. 3A, the output power (P) is plotted in dependence of the drive current ($I_{dr}$). As can be seen, the dotted curve, representing the etched mirror laser, is virtually identical with that of the cleaved mirror device on the same chip up to rather high output power values. The low threshold current of about 8 mA is also remarkable.

The far field beam pattern diagram of Fig.3B also shows that the quality of the etched mirrors virtually match that of the cleaved mirror devices. For most applications, the minor side loops, the only visible deviation of the dotted curve, are, for practical purposes, of no importance.

Further measurements of other device and process characteristic have confirmed that the inventive method leads to mirrors whose characteristics "as a whole" are very similar to those of cleaved mirrors and that the process leads to reproducible results: Measured reflectivity values of $R_e$ = 0.25 to 0.28 % are close to the figure $R_c$ = 0.32 % for a cleaved mirror; differential quantum efficiencies of more than 80 % were realized; surface roughnesses as low as about 10 nm have been obtained, and the threshold current values of a large number of laser devices formed on the same wafer were found to show only minor deviations.

**Claims**

1. A method of etching mirror facets of III-V compound semiconductor structures such as laser diodes and waveguides, applying an ion beam etch process in which a multi-layer mask is used for mirror definition,
   the method comprising the steps of
   - providing a substrate (11) on which the semiconductor structure (10) is deposited,
   - depositing and hard-baking, at a temperature above 200 °C, a bottom photoresist layer (21) onto the upper surface of the semiconductor structure,
   - evaporating an intermediate layer (22) of an amorphous dielectric material onto the bottom photoresist layer,
   - depositing and soft-baking, at a temperature below 120 °C, an imaging photoresist layer (23) onto the intermediate layer,
   - lithographic patterning of the imaging photoresist layer (23) to define the mirror etch position,
   - directional dry etching of the exposed areas of the intermediate layer (22) thereby transferring the pattern from the imaging photoresist layer (23) into the intermediate layer,
   - directional etching of the exposed areas of the bottom photoresist layer (21) thereby transferring the pattern from the intermediate layer (22) into the bottom photoresist layer,
   - removal of the intermediate layer by dry etching,
   - applying an ion beam etch process to etch a groove into the semiconductor structure to form the mirror facets, the patterned hard-baked bottom photoresist layer (21) serving as mask, and
   - removal of the bottom photoresist layer (21).

2. The method of claim 1, wherein the semiconductor structure is an GaAs/AlGaAs laser diode.

3. The method of claim 2, wherein the laser diode is of the graded-index separated confinement heterostructure type.

4. The method of claim 2, wherein a chemically assisted ion beam etch process is used for etching the groove into the laser diode structure.

5. The method of claim 2, wherein chlorine is used as reactive gas in the ion beam etch process.

6. The method of claim 4, wherein the water vapor pressure in the chemically assisted ion beam etch system is below $1,3 \times 10^{-6}$ Pa (= $10^{-8}$ Torr) to achieve non-selective etching of GaAs and AlGaAs.

7. The method of claim 2, wherein the bottom photoresist layer (21) is highly resistant to etching by the reactive gas used in the ion beam etch process.

8. The method of claim 2, wherein the bottom photoresist layer (21) is highly resistant to etching by chlorine, the ratio of the etch rate of the GaAs to the etch rate of the photoresist being higher than 30.

9. The method of claim 1, wherein the intermediate layer (22) consists of silicon monoxide.

10. The method of claim 1, wherein the thickness of the intermediate layer (22) is less than 200 nm, preferably less than 100 nm.

11. The method of claim 1, wherein the semiconductor structure is at least partly covered with an insulating layer (16) into which a window is etched during and with the same dry etching process used to remove the intermediate layer (22).

**Patentansprüche**

1. Ein Verfahren zum Ätzen von Spiegelfacetten an III-V-Halbleiterstrukturen wie beispielsweise Laserdioden und Wellenleitern, wobei ein Ionenstrahlätzverfahren angewendet wird, bei dem eine Mehrfachmaske zur Spiegelbestimmung verwendet wird,
   das Verfahren beinhaltet dabei folgende Schritte
   - Bereitstellen eines Substrats (11), auf der die Halbleiterstruktur (10) abgelegt wird,

- Ablegen und Hartbrennen bei einer Temperatur von über 200°C einer unteren Photolackschicht (21) auf der oberen Fläche einer Halbleiterstruktur,
- Aufdampfen einer Zwischenschicht (22) eines amorphen Dielektrikums auf der unteren Photolackschicht,
- Ablegen und Weichbrennen bei einer Temperatur unter 120°C einer Abbildungsphotolackschicht (23) auf der Zwischenschicht,
- lithographisches Strukturieren der Abbildungsphotolackschicht (23), um die Spiegelätzposition festzulegen,
- direktionales Trockenätzen der freien Bereiche der Zwischenschicht (22), wobei die Struktur von der Abbildungsphotolackschicht (23) auf die Zwischenschicht übertragen wird,
- direktionales Ätzen der freien Bereiche der unteren Photolackschicht (21), wobei die Struktur von der Zwischenschicht (22) auf die untere Photolackschicht übertragen wird,
- Entfernen der Zwischenschicht durch Trockenätzen,
- Anwenden eines Ionenstrahlätzverfahrens, um eine Grube zur Bildung der Spiegelfacetten in die Halbleiterstruktur zu ätzen, wobei die strukturierte, hartgebrannte Photolackschicht (21) als Maske dient, und
- Entfernen der unteren Photolackschicht (21).

2. Das Verfahren nach Anspruch 1, bei dem die Halbleiterstruktur eine GaAs/AlGaAs-Laserdiode ist.

3. Das Verfahren nach Anspruch 2, bei dem die Laserdiode aus einer "graded-index separated confinement"-Heterostruktur besteht.

4. Das Verfahren nach Anspruch 2, bei dem ein chemisch unterstützter Ionenstrahlätzprozeß zum Ätzen der Grube in die Laserdiodenstruktur verwendet wird.

5. Das Verfahren nach Anspruch 2, bei dem Chlor als reaktives Gas beim Ionenstrahlätzprozeß verwendet wird.

6. Das Verfahren nach Anspruch 4, bei dem der Wasserdampfdruck in dem chemisch unterstützten Ionenstrahlätzsystem unter $1,3 \times 10^{-6}$ ($= 10^{-8}$ Torr) beträgt, um ein nicht selektives Ätzen von GaAs und AlGaAs zu erzielen.

7. Das Verfahren nach Anspruch 2, bei dem die untere Photolackschicht (21) hochgradig resistent gegenüber dem Ätzen mit dem im Ionenstrahlätzprozeß verwendeten reaktiven Gas ist.

8. Das Verfahren nach Anspruch 2, bei dem die untere Photolackschicht (21) hochgradig resistent gegenüber dem Ätzen mit Chlor ist, wobei das Verhältnis der Ätzrate von GaAs im Vergleich zur Ätzrate des Photolacks höher als 30 ist.

9. Das Verfahren nach Anspruch 1, bei dem die Zwischenschicht (22) aus Siliziummonoxid besteht.

10. Das Verfahren nach Anspruch 1, bei dem die Dicke der Zwischenschicht (22) weniger als 200 nm beträgt, vorzugsweise weniger als 100 nm.

11. Das Verfahren nach Anspruch 1, bei dem die Halbleiterstruktur mindestens teilweise mit einer Isolierschicht (16) bedeckt ist, in die ein Fenster während und bei dem Trockenätzverfahren geätzt wird, wobei das Trockenätzverfahren auch zur Entfernung der Zwischenschicht (22) verwendet wird.

**Revendications**

1. Procédé pour graver des facettes de miroir dans des structures semiconductrices de composé III-V, comme des diodes laser et des guides d'ondes, appliquant une technique d'attaque par faisceau d'ions dans lequel un masque multicouche est utilisé pour définir le miroir,
   le procédé comprenant les étapes consistant à
   - fournir un substrat (11) sur lequel la structure semiconductrice (10) est déposée.
   - déposer et cuire fortement, à une température supérieure à 200°C, un photorésist inférieur (21) sur la surface supérieure de la structure semiconductrice,

- former par évaporation une couche intermédiaire (22) d'un corps diélectrique amorphe sur la couche de photorésist inférieure,
- déposer et cuire faiblement, à une température inférieure à 120°C, une couche de photorésist-image (23) sur la couche intermédiaire,
- former lithographiquement le motif de la couche de photorésist-image (23) pour définir la position de gravure du miroir,
- graver au plasma directionnellement les surfaces exposées de la couche intermédiaire (22) pour transférer le motif de la couche de photorésist-image (23) dans la couche intermédiaire,
- graver directionnellement les surfaces exposées de la couche inférieure de photorésist (21) pour transférer le motif de la couche intermédiaire (22) dans la couche inférieure de photorésist,
- ôter la couche intermédiaire par attaque au plasma,
- appliquer une technique d'attaque par faisceau d'ions pour graver un sillon dans la structure semiconductrice pour former les facettes de miroir, la couche inférieure de photorésist modelée fortement cuite (21) servant de masque, et
- ôter la couche inférieure de photorésist (21).

2. Procédé selon la revendication 1, dans lequel la structure semiconductrice est un diode laser GaAs/AlGaAs.

3. Procédé selon la revendication 2, dans lequel la diode laser est du type à hétérostructure à confinements séparés à gradient d'indice.

4. Procédé selon la revendication 2, dans lequel une technique d'attaque par faisceau d'ions assistée chimiquement est utilisée pour graver le sillon dans la structure de diode laser.

5. Procédé selon la revendication 2, dans lequel du chlore est employé comme gaz réactif dans le processus d'attaque par faisceau d'ions.

6. Procédé selon la revendication 4, dans lequel la pression de vapeur d'eau dans le système d'attaque par faisceau d'ions assistée chimiquement est inférieure à 1,3 x $10^{-6}$ Pa (= $10^{-8}$ Torr) pour réaliser l'attaque non-sélective du GaAs et du AlGaAs.

7. Procédé selon la revendication 2, dans lequel la couche de photorésist inférieure (21) est hautement résistante à l'attaque par le gaz réactif utilisé dans le processus d'attaque par faisceau d'ions.

8. Procédé selon la revendication 2, dans lequel la couche inférieure de photorésist (21) est hautement résistante à l'attaque par le chlore, le rapport entre la vitesse de gravure du GaAs et la vitesse de gravure du photorésist étant supérieur à 30.

9. Procédé selon la revendication 1, dans lequel la couche intermédiaire (22) est formée de monoxyde de silicium.

10. Procédé selon la revendication 1, dans lequel l'épaisseur de la couche intermédiaire (22) est inférieure à 200 nm, et est de préférence inférieure à 100 nm.

11. Procédé selon la revendication 1, dans lequel la structure semiconductrice est au moins en partie recouverte d'une couche isolante (16) dans laquelle une fenêtre est gravée au cours de, et avec, la même technique d'attaque au plasma que celle employée pour ôter la couche intermédiaire (22).

11

**FIG. 1A**

**FIG. 1B**

**FIG. 1C**

FIG. 2

(A)

(B)

(C)

(D)

(E)

(F)

(G)

FIG. 3A

P [mW]

FIG. 3B

BEAM INTENSITY

FWHM = 14°

BEAM ANGLE [6°/DIV]